# EUROPEAN PATENT SPECIFICATION

(11) **EP 1 548 807 B1**
(45) Date of publication and mention of the grant of the patent: **22.08.2018**
(21) Application number: 04447292.6
(22) Date of filing: 22.12.2004
(51) Int. Cl.: H01L 21/20, C30B 29/40, C30B 25/18

(54) **Method for depositing a group III-nitride material on a silicon substrate and device thereof**
Verfahren zur Abscheidung von einem Gruppe III-Nitrid-Material auf ein Siliziumsubstrat und entsprechende Vorrichtung
Méthode de dépôt d'un matériau nitrure du groupe III sur un substrat de silicium et dispositif correspondant

(30) Priority: 22.12.2003 US 531930 P; 02.04.2004 EP 04447087
(43) Date of publication of application: 29.06.2005
(73) Proprietor: IMEC VZW, 3001 Leuven (BE)
(72) Inventor: Borghs, Gustaaf, 3010 Leuven (BE); Degroote, Stefan, 3271 Scherpenheuvel (BE); Germain, Marianne, 4000 Liege (BE)
(74) Representative: Van Malderen, Joëlle

(56) References cited:
- FR-A- 2 836 159
- US-A1- 2003 216 043
- US-B1- 6 344 375
- BOUFADEN T ET AL: "GaN growth on porous silicon by MOVPE" MICROELECTRONICS JOURNAL, MACKINTOSH PUBLICATIONS LTD. LUTON, GB, vol. 34, no. 9, September 2003 (2003-09), pages 843-848, XP004438241 ISSN: 0026-2692

## Description

### Field of the invention

The present invention is related to a method for depositing a Group III-nitride material on a silicon substrate and a device therefor. It also relates to devices with epitaxial layers of improved quality.

### State of the art

Due to the lack of commercially available GaN substrates, GaN heterostructures are nowadays grown mainly on sapphire and SiC. Si is however a very attractive substrate, gaining more and more interest. Its main advantages are : an acceptable thermal conductivity (half of that of SiC) and its availability in large quantities and large wafer sizes. The most important advantage of Si compared to sapphire and SiC is its very low cost.

Kuykendall (NanoLetters 2003, Vol. 3, No. 8, 1063-10) discloses for instance the formation of GaN nanowires on silicon and sapphire substrates by MOCVD.

However, the growth of high quality epitaxial GaN layers directly on Si is not straightforward.

The high lattice mismatch between Si and GaN results in a high dislocation density in the GaN layer. This high dislocation density can be drastically decreased by adapting suitable growth recipes developed for the growth of GaN on sapphire.

The large difference in thermal expansion coefficient between GaN and Si induces large tensile stress in the GaN film during cooling down from the growth temperature to room temperature, resulting in cracking of the GaN layer. The phenomenon of cracking becomes problematic for layers with a thickness of 1 micron and more, and thus is detrimental for the performance of (opto)electronic devices.

Another problem for the growth of GaN directly on Si is the so-called meltback etching process of Ga and Si. At high temperatures, Ga and Si form an alloy, which initiates a strong and fast etching reaction destroying the substrate and the GaN layer. This results in a very rough surface.

Yet another problem relates to oxide formation on the Si substrate that requires specific attention, such as a careful cleaning just before loading samples in the reactor for the growth of GaN on the substrate.

A further problem for the growth of GaN on Si is the "bowing" of the substrate. When a layer of GaN is formed on Si, strain generated in the layer of GaN will consequently generate strain in the Si substrate. This results in deformation or the so-called 'bowing' of the Si substrate.

In patent application WO 03/054939 Aixtron discloses a method for depositing a III-V layer on a non III-V substrate, such as a silicon substrate. A III-V buffer layer or a III-V germination layer is deposited on the substrate by MOCVD.

For the growth of an active GaN layer, Boufaden et al. (Microelectronics Journal 34 (2003) 843-848) proposed to use a thin AlN layer to improve wetting between GaN and a porous Si/Si substrate. The AlN layer would reduce the lattice mismatch between GaN and Si to 2.5%. Also Orita et al. proposed in US-A-6344375 a buffer layer of AlN between a porous Si layer (PS) and a GaN epitaxial layer.

Different methods to reduce cracks and threading dislocations have been reviewed in 'GaN-Based Devices on Si', A. Krost and A. Dadgar, Phys.Stat.Sol. (a), Vol. 194, Issue 2, 2002, pp. 361-375*.*

The different approaches proposed to address the above-mentioned problems can be separated in two categories: those using a completely in-situ growth recipe and those requiring ex-situ processing steps followed by subsequent growth steps. The former group is based on strain engineering, using proper seed-, super- or interlayers, to avoid cracking and to reduce as much as possible the threading dislocation density existing in the active GaN layer. The latter group aims at controlling the geometrical distribution of the thermal cracks and of the threading dislocations. ELOG, Pendeo, Cantilever Epitaxy all lead to high quality areas, while other concentrates all the threading dislocations and/or cracks arising from the stress.

FR 2 836 159 describes a device and a method wherein a cubic silicon carbide layer, or a layer of a nitride of an element of group III, is formed on a monocrystalline substrate made from silicon germanium.

### Aims of the invention

The present invention aims to provide a novel method for depositing a Group III-nitride material on a silicon substrate overcoming the problems of the prior art solutions.

Another aim is to provide devices with a high-quality Group III-nitride epitaxial layer.

Yet another aim is to provide suitable intermediate template devices for growth of such a high-quality epitaxial Group III-nitride layer.

### Summary of the invention

In a first aspect of this invention a device is disclosed comprising
- a substrate comprising a silicon substrate having a porous top layer,
- a second layer on said top layer, said second layer made of a Ge material, and
- a further layer of a Group III-nitride material on said second layer.

By a "porous top layer" in the present context is meant amongst others a top layer consisting essentially of porous silicon (PS) but also an artificially created porous material, like a castellated or a two-dimensional submicron patterned top layer.

Such "porous top layers" provide a rough, textured, non-flat, preferably 3-D structured surface and a supple skeleton. Voids, bubbles or inclusions may be present under the surface of such porous top layer. The closure of pores at the surface of the porous top layer can lead to the formation of voids, bubbles, inclusions, micropores etc.

"Porous top layer" means that at least part (possibly essentially all or all) of the pores are open at the surface of said top layer, but some (at least part) of the pores at the surface may be closed. Alternatively, under the surface in the substrate all or part of the pores may be closed and voids, bubbles, inclusions or micropores can be formed in the substrate.

In case of a further layer being deposited on the top layer or in case of an annealing treatment all the pores may be considered closed pores.

In an embodiment of the first aspect of this invention, a device as recited in any of the previous embodiments is disclosed wherein the porous top layer comprises at least in part closed pores such as voids, inclusions, bubbles or micropores.

A gradient in porosity may exist in the porous top layer according to a preferred embodiment of the invention. Preferably the pore size and/or amount of pores increases in a direction away from the surface of the top layer.

Top layers with at least a double porosity may be advantageous. Hereby is meant that at least two sublayers with different porosity are present in said top layer. The difference may again lay in the size of the pores and/or in the amount of pores.

It is also possible to have a stacking of layers with a high and low porosity, meaning that layers with a high and low porosity alternate. A high porosity refers to the presence of large pores and/or to the presence of a high amount of pores compared to the presence of small-sized pores and/or the presence of a lower amount of pores (low porosity). Ways of creating layers of high and low porosity are known in the art.

It may be advantageous to create a separation layer under a high porosity sublayer in contact with a silicon substrate, for instance by high temperature annealing in hydrogen. This separation layer is a highly porous layer and is mechanically very weak. It can easily be broken by little mechanical force, e.g. by ultrasonic treatment or pulling (see e.g. EP 1132952).

The porous top layer according to the invention typically has a porosity between 10 % and 90 %. It typically has a thickness of between 10 nm and 10 *µ*m, between 10 nm and 3 *µ*m.

"Porous top layers" according to the invention are able to relax strain after growth. Furthermore, the epitaxial layer can be separated from the substrate by stress release.

By a "layer made of a Ge material" is meant a layer made of a material that comprises at least Ge.

In a preferred embodiment of the first aspect of this invention, a device as recited in any of the previous embodiments is disclosed wherein the second layer is made of a SiGe material (a material comprising at least SiGe). The second layer can be a SiGe layer. The composition of the layer made of a Ge material, preferably a SiGe material, is optionally graded. Advantageously the Ge concentration in said material of said second (graded) layer is increased in a direction away from the substrate.

In a preferred embodiment of the first aspect of this invention, a device as recited in any of the previous embodiments is disclosed wherein the Group III-nitride material comprises at least GaN. In a preferred embodiment of the first aspect of this invention, a device as recited in any of the previous embodiments is disclosed wherein the Group III-nitride material is GaN.

Alternatively, the Group III-nitride material may comprise at least AlN or may be AlN. Another possibility is to grow for instance a Group III-nitride epitaxial layer comprising at least AlGaN.

Advantageously, a device as recited in any of the previous embodiments is disclosed wherein the second layer is in direct contact with said top layer. Advantageously, a device as recited in any of the previous embodiments is disclosed wherein the Group III-nitride layer, for instance a GaN layer, is in direct contact with the second layer.

In an embodiment of the first aspect of this invention, a device as recited in any of the previous embodiments is disclosed wherein the second layer (made of a Ge material such as SiGe) has a thickness between 1 nm and 1000 nm or 2000 nm, and more preferably between 1 nm and 500 nm, even more preferably between 1 nm and 300 nm, between 10 nm and 200 nm.

The thickness of a layer of a Ge material preferably is between 1 nm and 100 nm, between 1 nm and 50 nm, between 1 nm and 20 nm, between 1 nm and 15 nm, between 1 nm and 10 nm. The thickness of a layer comprising a Ge material preferably is between 1 nm and 20 nm, more preferably between 5 and 15 nm, most preferably between 6 and 12 nm.

In a preferred embodiment of the invention, a device according to the invention is disclosed wherein the top layer is a porous top layer according to the invention, the second layer is made of a SiGe material (e.g. a SiGe layer) and wherein the further layer is a GaN layer. Advantageously the layer of a SiGe material, such as a SiGe layer, is in direct contact with said top layer. Advantageously the GaN layer is in direct contact with this second layer. The thickness of the second layer in the here described embodiment is preferably between 1 nm and 2 micrometer, between 1 nm and 1000 nm, between 1 nm and 500 nm, between 1 nm and 300 nm and between 10 nm and 200 nm.

Pores in the top layer may be open pores or may present a combination of closed and open pores. As such, another particularly preferred device according to the invention is one wherein the porous top layer according to the invention comprises at least in part closed pores, wherein the second layer is made of a SiGe material (e.g. a SiGe layer) and wherein the further layer is a GaN layer. Substantially all pores (over 70 %, 80% or 90% or 95 % of the pores) may be closed pores.

Examples of closed pores include but are not limited to bubbles, inclusions, voids or micropores. Micropores have a small diameter of reduced size (compared to the diameter of the initial pores in the porous Si substrate) as a consequence of for instance an annealing step before deposition of a Group III-nitride layer. The temperature of the annealing step is advantageously higher than the temperature of the step of depositing the group III-nitride material. The deposition temperatures for GaN is between 500°C and 1100°C, typically about 1050°C while the annealing temperature is then higher than 1100°C, and preferably between 1100°C and 1200°C.

In a preferred embodiment of the invention, a device according to the invention is disclosed wherein the second layer is a layer made of Ge or is a layer made of graded SiGe, and wherein the further layer is a GaN layer. Advantageously the Ge concentration in the graded SiGe increases in a direction away from said substrate.

The device as recited in any of the previous embodiments can further advantageously comprise an intermediate (third) layer. The intermediate layer is between the second layer (the layer made of a Ge material, like a SiGe material) and the Group III-nitride layer (the further layer). The intermediate layer advantageously is arranged such that it can serve as a basis for the growth of the Group III-nitride layer or as layer from which the growth of the Group III-nitride layer starts. It can advantageously be is kind of a nucleation layer. The intermediate layer, can be a layer with a thickness in the range between 1 nm and 200 nm, between 1 nm and 100 nm and between 1 nm and 50 nm. The intermediate layer can be a flat continuous layer or can be a discontinuous layer comprising for instance islands. The intermediate layer can be an AlN layer.

In another embodiment of the invention, a device according to the invention is disclosed wherein the second layer is a layer made of Ge or is a layer made of graded SiGe, wherein the intermediate layer is a layer made of AlN, and wherein the further layer is a GaN layer. Advantageously the Ge concentration in the graded SiGe increases in a direction away from said substrate.

In another embodiment of the invention, a device according to the invention is disclosed wherein the second layer is a layer made of SiGe, and wherein the further layer is an AlN layer.

The invention also relates to a FET, a LED, a laser diode, a HEMT (high electron mobility transistor) or a heterojunction bipolar transistor comprising a device according to the invention recited in any of the previous embodiments of the invention.

In a specific embodiment of the first aspect of this invention, a device as recited in any of the previous embodiments is disclosed wherein an electronic circuitry is integrated in the silicon substrate. The device may also comprises an optoelectronic element or a FET formed in the Group III-nitride layer.

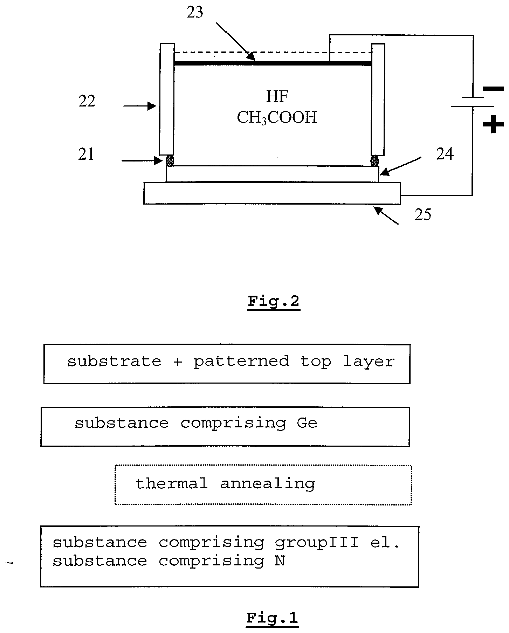

A second aspect of this invention relates to a method for forming a device comprising a Group III-nitride material on silicon, comprising the steps of (see Figure 1):
- providing a silicon substrate comprising a porous top layer (as defined),
- subjecting said silicon substrate with said porous top layer to a Ge comprising substance, thereby forming a (second) layer of a Ge material on said top layer,
- subjecting the silicon substrate with the layer of a Ge material to a substance comprising a Group III element and a substance comprising N, thereby forming a further layer of a Group III-nitride material on said second layer.

In a preferred embodiment of the second aspect of this invention, a method as recited in any of the previous embodiments is disclosed wherein the method further comprises the step of thermally annealing the layer made of a Ge material prior to the step of subjecting the silicon substrate with said layer of a Ge material to a substance comprising a Group III element and a substance comprising N (optional step in Figure 1). Advantageously the step of thermally annealing is performed at a temperature between 500°C and 1300°C and more advantageously between 500°C and 1100°C.

Preferably the step of subjecting the silicon substrate with the porous top layer to a substance comprising Ge is performed by plasma enhanced chemical vapour deposition (PECVD), thermal evaporation, close space vapour transport or molecular beam epitaxy.

Advantageously after deposition of the second layer, the (intermediate) device may be stored for a predetermined period, id est for hours, weeks, months or even years, without the necessity of having to store the device under a protective atmosphere (like a N₂ atmosphere). As such, advantageously, a method as recited in any of the previous embodiments is disclosed wherein an intermediate device is stored after the step of forming the second layer on said top layer.

Preferably the step of subjecting the silicon substrate with the layer of a Ge material to a substance comprising a Group III element and a substance comprising N is performed by a metal organic chemical vapour deposition (MOCVD) process. This step is typically performed at a temperature between 500°C and 1300°C, between 1000 and 1100 °C, and preferably at 1050°C.

Alternatively, the step of subjecting the silicon substrate with the layer of a Ge material to a substance comprising a Group III element and a substance comprising N can be performed by a molecular bean epitaxy (MBE) or Hydride vapour phase epitaxy (HVPE).

The step of subjecting the silicon substrate with the layer of a Ge material to a substance comprising a Group III element and a substance comprising N can advantageously be preceded by an annealing step. The annealing step results in the formation of a stable layer. For example, the structure of the porous top layer and the second layer can change during the annealing step. Consequently, the underlying layers will be less susceptible for structural changes (such as, but not limited hereto, changing of the pores structure) during the step of subjecting silicon substrate with the layer of a Ge material to a substance comprising a Group III element and a substance comprising N. Also, after the annealing step, the second layer will be a layer made SiGe.

In a preferred embodiment of the second aspect of this invention, a method as recited in any of the previous embodiments is disclosed, wherein the Group III element is Ga. Most preferably the Group III-nitride is GaN. The Group III nitride material can also be AlN or AlGaN.

In another preferred embodiment of the second aspect of this invention, a method as recited in any of the previous embodiments is disclosed, wherein the Group III element is Al, and the Group III-nitride AlN.

In a preferred embodiment of the second aspect of this invention, a method as recited in any of the previous embodiments is disclosed, wherein said method further comprises the step of forming an intermediate layer between the step of subjecting said silicon substrate with said porous top layer to a substance comprising Ge and the step of subjecting said silicon substrate with said layer of a Ge material to a substance comprising a Group III element and a substance comprising N. Advantageously an intermediate AlN layer is hereby formed.

The AlN (intermediate) layer can be deposited by MOCVD in the MOCVD reactor at high temperature such as between 900°C and 1200°C. Alternatively, the AlN layer can be grown at low temperature such as between 400°C and 900°C, between 500°C and 800°C, followed by a thermal annealing step.

In a preferred embodiment of the second aspect of this invention, a method as recited in any of the previous embodiments is disclosed, wherein the deposition of a Group III-nitride layer, such as a GaN layer, is performed at two different temperatures between 500°C and 1300°C. Advantageously, the first part of said deposition step is performed at a lower temperature, (e.g. a temperature of between 400°C and 800°C, of between 400°C and 700°C, of between 400°C and 600°C) followed by a step at higher temperature (e.g. a temperature of between 800°C and 1200°C, of between 800°C and 1100°C, of between 800 and 1000°C).

A third aspect of the invention relates to a device obtainable by any of the above described methods. Examples of such devices, obtainable by any of the above disclosed methods according to the invention, are given in the section related to the first aspect of the invention.

A fourth aspect of this invention relates to a method for forming an (intermediate) template device for the deposition of a Group III-nitride material, said method comprising the steps of
- providing a silicon substrate comprising a porous top layer,
- subjecting said silicon substrate with porous top layer to a substance comprising Ge, thereby forming on said top layer a second layer, said second layer made of a material comprising Ge,
- optionally followed by the step of thermally annealing said (second) layer made of a material comprising Ge.

Preferred embodiments with respect to ways of forming the different layers, their composition and thickness have been described in the sections related to aspects 1 to 3 of the present invention.

This method results in a template device highly suitable for the deposition of a Group III-nitride material, said template device comprising a substrate that comprises a silicon substrate having a porous top layer, and on said top layer a second layer, said second layer made of a material comprising Ge. Advantageously, said top layer is arranged such that a Group III-nitride material can be deposited on said second layer. Advantageously at least part of the pores of the top layer may be closed pores. Still a further aspect of the invention relates to template devices obtainable by a method of forming such template device according to the invention.

Yet a further aspect of the present invention relates to the use of an (intermediate) template device for the deposition of a Group III-nitride material, said template device comprising a substrate that comprises a silicon substrate having a porous top layer, and a second layer on said top layer, said second layer made of a material comprising Ge. Advantageously, said top layer is arranged such that a Group III-nitride material can be deposited on said second layer. Advantageously at least part of the pores of the top layer may be closed pores or pores with reduced diameter. Possible thickness and/or layer composition, etc are as indicated in the sections related to the first and second aspect of the present invention.

### Short description of the drawings

Fig. 1 represents a flow chart showing the (mandatory and optional) steps of the method. Optional steps are indicated by a dotted line.
Fig. 2 represents a pSi formation set up.
Fig. 3a represents the reflectivity as a function of time. Fig. 3b represents XRD measurements.
Figure 4 represents a porous silicon substrate with a gradient in porosity, from low to high porosity.
Figure 5 represents a porous silicon substrate, comprising a silicon substrate (53), a layer of low (51) porosity and a layer of high (52) porosity .
Figures 6a-f represent different steps in the formation of a porous top layer on a silicon [001] substrate by way of anodisation in a HF-based solution as described for instance in EP 1132952. The numeral 61 indicates the silicon substrate, 62 indicates pores, 63 indicates the point of reaction, 64 indicates a hydrogen molecule and 65 is the direction of the hydrodynamic force exerted by the molecule.

### Detailed description of the invention

The present invention is described in detail in the sequel. It is apparent however that a person skilled in the art can imagine several other equivalent embodiments or other ways of executing the present invention.

For the purpose of this invention, when a layer is referred to as being "on" or "over" another layer or substrate, it is meant that the layer is directly on the other layer or substrate or that an intermediate layer is present. When a layer is referred to as being "in direct contact with" another layer or substrate, it is meant that there is no intermediate layer present between the two layers or between the layer and the substrate.

For the purpose of this invention, a Group III-nitride material is a material comprising a nitride of an element of Group III of the periodic table of elements. A Group III-nitride material can be GaN, whereby GaN is to be understood as a material comprising at least GaN, such as, but not limited hereto, AlN, AlGaN, InGaN, AlInGaN, GaAsPN and the like. The device as recited in this invention can also comprise a diamond layer instead of a Group III-nitride material.

A silicon substrate is a substrate comprising silicon. In a specific embodiment the silicon substrate is a silicon wafer. The silicon substrate can comprise a porous top layer according to the invention (as defined above) .

By "castellated" is meant that the cross section of the substrate at the major surface is characterized by steep hills and valleys, the tops of the hills defining flat plateau surface portions that are mutually separated from one another by gaps formed by the valleys. Advantageously, each of the plateaus has a maximum lateral extent of less than a micron, preferably of less than 200 Angstrom and most preferably of less than 100 Angstrom, with respect to any direction along the top surface of the plateau. Preferably, neighbouring plateaus are separated from one another by gaps of at least 30 Angstrom, more preferably of at least 60 Angstrom wide

By "two-dimensionally submicron patterned" is meant that the surface is characterized by flat plateaus of any arbitrary shape, each plateau having a maximum lateral extent with respect to any direction along the top surface of the plateau of less than a micron, with gaps formed by grooves located between the plateaus, for example, as obtained by nanometer lithography described by Douglas et al. (Applied Physics Letters (1986), vol 48 (10) 676-678).

The term "pores" in the present context extends to the "gaps", "valleys" or "grooves" as described above. The "pores" in the porous top layer according to the invention may be open pores or may present a combination of open and closed pores such as bubbles, inclusions, voids or micropores.

In case of a further layer being deposited on the porous top layer or in case of an annealing treatment all the pores may be considered closed pores.

In a first aspect of this invention, a device is disclosed, the device comprising
- a substrate comprising a silicon substrate having a porous top layer,
- a second layer on said top layer, said second layer made of a Ge material, and
- a further layer of a Group III-nitride material on said second layer.

Preferably, the second layer comprises SiGe. The Group III-nitride material preferably comprises at least GaN. Preferably the Group III-nitride material is GaN. Alternatively, the Group III-nitride material may comprise at least AlN or be AlN.

The lattice mismatch between Si and a Group III nitride material is very high. By adding Ge to Si and performing an annealing step a layer of SiGe is formed, having an even higher lattice mismatch.

Also the difference in thermal expansion coefficient between the two materials (Si and a Group III-nitride material) is very high, resulting in extra stress in the Group III-nitride layer such as a GaN layer during cooling down after the GaN deposition.

The difference in thermal stress between Si and the group III nitride material, preferably GaN, will decrease when a SiGe layer is formed between Si and the Group III-nitride material. Consequently, the occurrence of cracks in the group III nitride material layer is decreased.

On one hand, the layer of a Ge material thus drastically reduces thermal stress, which in fact appears to be the major bottleneck for growth of a Group III-nitride material such as GaN on Si and not the lattice mismatch.

Dislocations in the Group III-nitride material such as GaN layer may still occur. This problem can be solved by the use of a porous Si layer according to the invention, which is very flexible. The porous Si layer according to the invention will allow the substrate to accommodate to the large lattice mismatch between silicon and the Group III-Nitride layer, and thus reduces the dislocation density in the latter layer. Moreover, use of the substrate according to the invention will avoid cracks of the Group III-nitride layer during cooling of the device. A further advantage is the fact that "bowing" of the substrate is avoided.

The substrate choice (silicon with a porous layer according to the invention) is not straightforward : Porous Si is thermally instable (it can deform at high temperatures) and can absorb moisture from the environment.

The layer of a Ge material is deposited at a temperature between 300 °C and 800 °C , preferably at 500°C, in contrast to the high depositions temperatures for AlN and GaN standardly used in the art.

On the other hand, a layer of a Ge material such as a Ge layer thus mainly acts as a protective layer to avoid oxidation of the porous Si according to the invention. Consequently the structural modification of the porous Si layer is avoided. GaN layers or AlN layers grown directly on a silicon substrate according to the invention would not prevent oxidation of the porous Si substrate.

In addition, the deoxidation temperature of Ge is much lower than the critical temperature at which porous Si recrystallises into (bulk) Si with voids, whereas the deoxidation temperature of Si is well above this transition temperature. Voids can be considered as micropores in the porous Si.

The Ge interlayer will also prevent nitridation of the Si substrate so that no or a minimal amount of amorphous SiNₓ compounds can be formed at the interface. Formation of amorphous thick SiNₓ materials is highly disadvantageous with respect to further epixial growth of the device. The Ge interlayer also reduces the intermixing of Ga and Si and thus prevents meltback etching.

The advantageous effects of a second layer made of a Ge material according to the invention are obtained already when a very thin layer of a material comprising Ge is applied on top of a Si substrate with a top layer according to the invention, for instance a layer with a thickness of between 1 and 20 nm, 5 and 15 nm, 6 and 12 nm.

A device as obtainable by a method according to the invention is a device of high quality.

It was found that a layer of a Ge comprising material on a Si substrate having a top layer according to the invention provides a surface that is highly suited for the epitaxial growth of high-quality wide band gap Group III-nitride semiconductor materials, in particular for the growth of GaN. Epitaxial layers of high quality were obtained as such, with excellent crystallinity, very few cracks and reduced bowing compared to growth on a nonporous Si substrate without a layer of a Ge material.

Below some preferred devices according to the invention are described:

A first such device is one that comprises :
- a substrate comprising a silicon substrate having a porous top layer,
- on said porous top layer a second layer, said second layer made of material comprising SiGe, and
- a GaN layer on this second layer.

Pores in said porous layer may be open pores, or may be a combination of closed and open pores.

In an embodiment of the invention the layer of a SiGe material (a material comprising at least SiGe) is in direct contact with said top layer. In a specific embodiment the GaN layer is in direct contact with the layer of a SiGe material. The second layer advantageously is a SiGe layer.

The thickness of the layer of a SiGe material in the here described embodiment is between 1nm and 2 micrometer, between 1 nm and 1000 nm, between 1 nm and 500 nm, between 1 nm and 300 nm and between 10 nm and 200 nm.

Another preferred device is one that comprises :
- a substrate comprising a silicon substrate having a porous top layer comprising at least in part closed pores,
- on said top layer a second layer, said second layer made of material comprising SiGe, and
- a further GaN layer on this second layer.
The second layer advantageously is a SiGe layer.

The substrate comprising a silicon substrate having a top layer comprising at least in part closed pores, for instance voids, is for instance formed after deposition of the GaN layer and cooling down. During the first step in the deposition process of GaN (this is the annealing step) the porous silicon layer is transformed into bulk Si comprising voids.

The invention also discloses a device comprising a substrate and a layer of a Group III-nitride material. In an embodiment the device comprises :
- a substrate comprising a silicon substrate having a porous top layer,
- on said top layer a second layer, said second layer being a Ge layer or a graded SiGe layer, and
- a GaN layer on said second layer.

Advantageously, the second layer made of Ge material, like a Ge layer or a layer made of graded SiGe, is in direct contact with said top layer. Advantageously, the Ge concentration in said graded SiGe increases in a direction away from said substrate. Advantageously the GaN layer is in direct contact with the second layer.

The porous Si layer and the Ge layer will diffuse, resulting in the formation of a SiGe layer, possibly a graded SiGe layer, at least in the lower part of the layer, id est the part near the Si substrate.

The thickness of the Ge layer or of the graded SiGe layer in the here described embodiment is between 1 nm and 1000 nm, between 1 nm and 500 nm, between 1 nm and 300 nm and between 10 nm and 200 nm. More preferably, the thickness of the Ge layer or of the graded SiGe layer is between 1 and 100 nm, between 1 and 50 nm, between 1 and 20 nm, between 1 and 15 nm, between 1 and 10 nm.

The substrates according to the invention, disclosed in any of the above embodiments, are very useful for the epitaxial growth of high-quality wide band gap Group III-nitride semiconductor materials, in particular for the growth of GaN. In particular, substrates prepared according to a method comprising an annealing step and/or comprising a Group III-nitride deposition in two steps (a first step at a lower temperature, followed by further growth at higher temperatures) and/or with a Ge layer are highly suitable for these purposes.

All of the above described devices can be at least a portion of a device region. The device can be part of a FET, a LED, a laser diode, a HEMT or a heterojunction bipolar transistor.

In another aspect of the invention the use of e.g. a Si/pSi/SiGe substrate for the growth of a Group III-nitride material is disclosed, where pSi denotes porous Si according to the invention. The Si/pSi/SiGe substrate, also referred to as template device, comprises a silicon substrate having a porous top layer and a layer of a SiGe material (second layer) on said top layer. The term "Si/pSi/SiGe substrate" in fact refers to all template devices disclosed in the present invention, id est devices with a layer made of a Ge material (preferably a SiGe layer) as second layer.

By using the Si/pSi/SiGe substrate according to the invention for the growth of Group III-nitride materials, the problems of the prior art solutions are solved. Moreover, the Si/pSi/SiGe substrate of the invention, preferably with at least part of the pores closed, can be formed and stored until deposition of the Group III-nitride material. The storage can be for a few hours, a few days, a month or even longer.

In a further aspect of this invention, a method for forming a template device as described above is disclosed. The method comprises the steps of :
- providing a silicon substrate comprising a porous top layer,
- subjecting said silicon substrate with said porous top layer to a substance comprising Ge, thereby forming on said top layer a second layer, said second layer made of a material comprising Ge, preferably
- followed by the step of thermally annealing said layer made of a material comprising Ge.

The step of providing a silicon substrate and the step of subjecting said silicon substrate to a Ge comprising substance can be performed and the resulting substrate can be stored. The step of subjecting said substrate with said layer of a Ge material to a Group III element comprising substance and an N comprising substance can be performed when the device needs to be further processed.

Advantageously said annealing step is performed prior to subjecting said silicon substrate with said layer of a Ge material to a Group III element comprising substance and an N comprising substance. In a preferred embodiment the Group III element is Ga. Alternatively the Group III element may be Al.

The step of thermally annealing said layer of a Ge material prior to the step of subjecting said layer to a Group III (e.g. Ga) comprising substance results in the removal of the oxide (formed on the Ge layer) and the formation of a layer of a SiGe material, possibly a graded SiGe material, on the porous Si top layer. The thermally annealing step is advantageously performed at a temperature between 500°C and 1300°C, preferably between 500°C and 1100°C.

The step of subjecting the silicon substrate with the porous top layer to a Ge comprising substance avoids the formation of SiO2 on the porous top layer. From the prior art (see 'Atmospheric impregnation of porous silicon at room temperature', Canham et al., J. Appl. Phys. 70(1), July 1991, pp. 422-431*),* it is known that a clean fluorinated hydride surface of freshly etched silicon substrates is converted to a contaminated native oxide during the exposure to ambient air for longer time, resulting in a continuous modification of the structural properties.

The method of the invention may further comprise the step of subjecting said silicon substrate with said Ge layer to a Group III element comprising substance and an N comprising substance, thereby forming a Group III-nitride layer on the second layer.

The method can further comprise the step of forming an intermediate (third) layer between the second layer of a Ge material and the Group III-nitride layer (the further layer). The intermediate layer advantageously is arranged such that it can serve as a basis for the growth of the Group III-nitride layer or as layer from which the growth of the Group III-nitride layer starts. The intermediate layer can be a layer with a thickness in the range between 1 nm and 200 nm, between 1 nm and 100 nm and between 1 nm and 50 nm. The intermediate layer can be a flat continuous layer or a discontinuous layer comprising islands. The intermediate layer can be an AlN layer.

The intermediate AlN layer can introduce reasonable compressive stress in the GaN layers grown over it, which during cooling down of the heterostcrutures compensate large thermal tensile stress due to thermal mismatch and further reduce cracking.

The thickness of the AlN layer preferably is between 1 nm and 2 micrometer , between 10 nm and 1000 nm, between 10 nm and 500 nm. The AlN layer preferably is grown at a temperature between 500°C and 900°C or between 900°C and 1100°C.

The step of subjecting the silicon substrate with the porous top layer to a Ge comprising substance can be performed by plasma enhanced chemical vapour deposition (PECVD), thermal evaporation, close space vapour transport or molecular beam epitaxy.

Deposition of a layer of a Ge material such as a Ge layer typically takes a few seconds. After the process of preparing a porous silicon substrate, this substrate with porous top layer according to the invention may be stored for a few seconds, for minutes or a few hours (up to 2 hours) under a protective atmosphere (like an N₂ atmosphere), whereafter the layer of a Ge material is then deposited.

For the step of subjecting said layer of a Ge material such as a Ge layer to a Group III element comprising substance and a N comprising substance to grow a Group III-nitride layer, the wafer is preferably loaded in a metal organic chemical vapour deposition (MOCVD) reactor. The wafer can also be loaded in an MBE reactor or a HVPRE reactor. Prior to deposition the substrate is annealed in H₂ atmosphere for instance to remove the oxide. During this annealing step a stable epitaxial Ge-silicide layer is formed.

The substance comprising a Group III element can be TMGa (trimethyl Gallium) while the N comprising substance can be NH₃. In an embodiment the step of subjecting said layer of a Ge material to a Group III element comprising substance and a N comprising substance can be performed at a temperature between 500°C and 1300°C, preferably between 1000°C and 1100°.

Alternatively the step of subjecting said layer of a Ge material to a Group III element comprising substance and a substance comprising N can be performed at two different temperatures between 500°C and 1300°C. The first part of the step may be performed at a lower temperature, (e.g. a temperature of between 400°C and 800°C) followed by a step at higher temperature (e.g. a temperature of between 800°C and 1200°C).

The step of subjecting said layer of a Ge material to a substance comprising a Group III element and a substance comprising N results in the formation of a layer of Group III-nitride material. Advantageously the layer of Group III-nitride material is a material comprising at least GaN. Alternatively, the layer of Group III-nitride material may be a material comprising at least AlN.

In an embodiment, the substrate can be formed starting from a Si wafer, of which the top layer is made porous by a method known to a person skilled in the art. In an embodiment the top layer can be made porous for instance by an anodic reaction with concentrated hydrofluoric (HF) acid.

### Example :

Porous Si (pSi) is obtained by anodisation in a HF-based solution, using a two-electrode configuration (see figure 2) with a silicon working electrode (24) and a platinum counter electrode (23). Acetic acid is added to the HF as a surfactant to allow an efficient removal of the hydrogen bubbles formed during the pSi formation and results in a more homogeneous pSi layer. During the anodisation of the Si(111) substrate (21), the electrochemical dissolution of the Si atoms occurs in the vicinity of the interface between the already formed pSi layer and the Si substrate. Therefore the thickness of the pSi layer is controlled by the etching time. The relevant parameters for the pore formation are the current density, the doping type and level of the substrate, the electrolyte concentration and the possible illumination of the wafer. Since holes at the electrode surface are required for the dissolution of silicon, p-type silicon is readily etched in the dark, while with n-type material illumination is required. Porous layers with a porosity ranging from 10% to 90% and a thickness varying from 10 nm to a few micrometers can easily be achieved. This process results in homogenous porous layers over large wafer areas. Fig.2 shows a pSi formation set up. 21 refers to the silicon substrate, 22 refers to the Teflon beaker, 23 to the Platinum electrode, 24 to the silicon anode and 25 refers to the back contact. The specific process conditions are :
anodisation 2" p-Si(lll)
thickness : 280 mm
resistivity : 0.01 Wcm
chemical solution : 2 HF / 3 Acetic Acid
current density : 75 mA/cm²
This process results in 1.7 mm porous Si layer with a porosity of ∼30%.

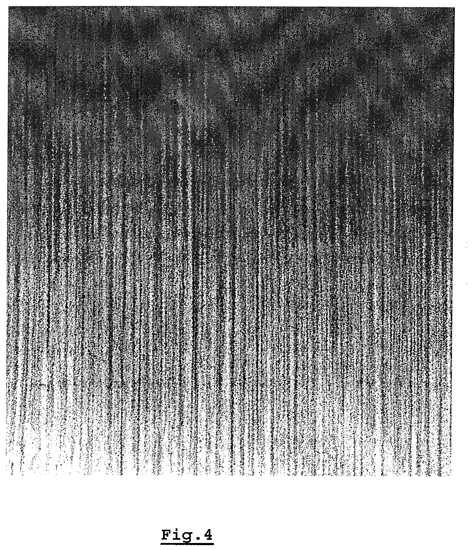

Figure 4 refers to a porous Si [001] substrate obtained by the method as described above.

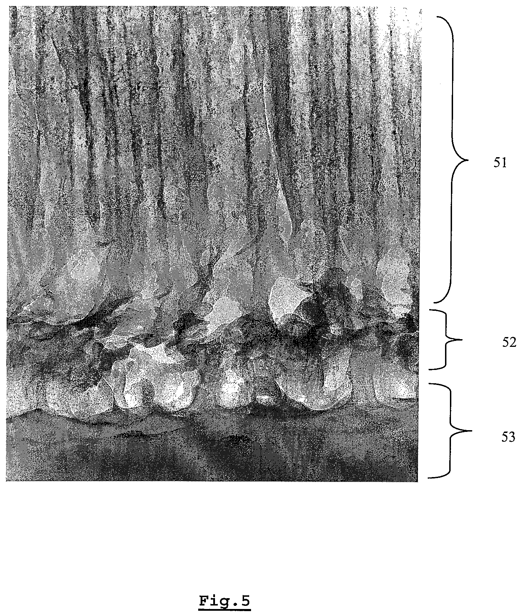

Figure 5 represents a porous silicon [001] substrate, comprising a silicon substrate (53), a layer of low (51) porosity and a layer of high (52) porosity.

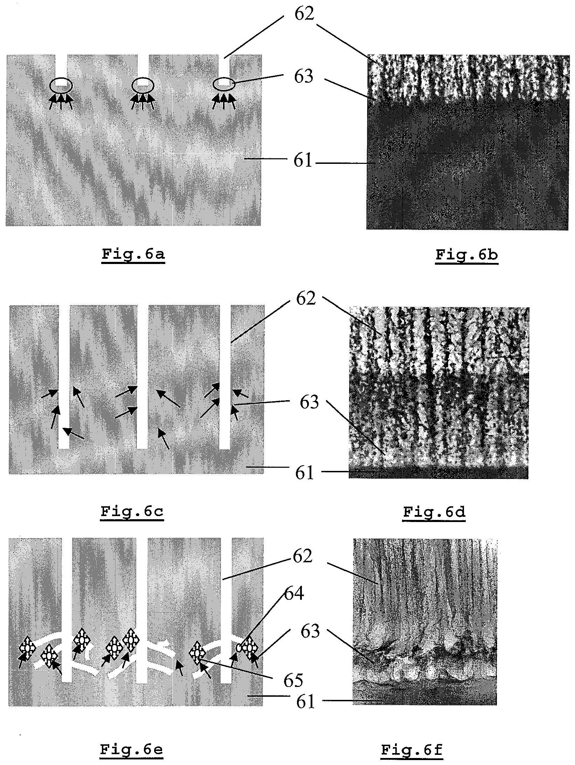

Figures 6a-f represent different steps in the formation of a porous top layer on a silicon [001] substrate by way of anodisation in a HF-based solution as described for instance in EP 1132952. The numeral 61 indicates the silicon substrate, 62 indicates pores, 63 indicates the point of reaction, 64 indicates a hydrogen molecule and 65 is the direction of the hydrodynamic force exerted by the molecule.

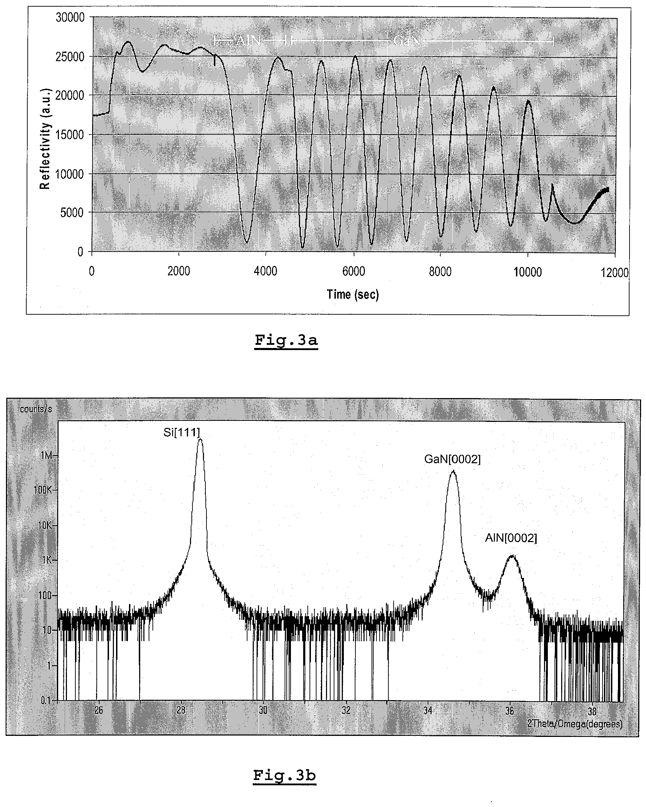

After the pSi formation the wafer is thoroughly rinsed in DI-water until no traces of the electrolyte remain. The substrate is subsequently dried with N₂ and immediately loaded in a vacuum system to deposit the layer of a Ge material such as a Ge layer. Immediately meaning that no oxidation of the porous Si occurs. The Ge is deposited in a Plasma Enhanced CVD system at a moderate temperature of about 500°C and has a thickness in the range of 10 to 100 nm. PECVD results in the formation of epitaxial layers of a Ge material such as Ge layers on top of the Si substrate, as can be concluded from XRD analysis of the PECVD Ge layer. Fig.3 shows a reflectivity and XRD measurement illustrating the growth of a epitaxial layer of GaN on top of the pSi (111).

This step is followed by a degassing and annealing step at 1125 degrees C, resulting in the formation of a layer of a SiGe material such as a SiGe layer.

In a next step, the substrate is subjected to TMAl and NH₃ in an MOCVD reactor and an intermediate layer of AlN is formed at 1100 degrees C (rate : 7.5 nm/min, thickness 200 nm).

After depositing the layer of a Ge material such as a Ge layer, the substrate is loaded in a MOCVD reactor. The substrate is subjected to TMGa and NH₃ at 1020 degrees C (rate 10 nm/min, thickness 1 µm). The resulting reflectivity (fig. 3a) and XRD measurements (Fig. 3b) show that a smooth epitaxial GaN layer is formed on top of the porous Si(111).

## Claims

1. A device comprising:
• a substrate comprising a silicon substrate having a top layer, said top layer being :
- a top layer consisting essentially of porous Silicon, or
- a castellated top layer, or
- a two-dimensionally submicron patterned layer,
• a second layer on said top layer, said second layer being a Ge layer or a SiGe layer, and
• a further layer of a Group III-nitride material directly on said second layer or on an intermediate layer present on said second layer.

2. A device as in any of the previous claims, wherein the composition of said second layer is graded.

3. A device as in any of the previous claims, wherein the Ge concentration in said material of said second layer is increased in a direction away from said substrate.

4. A device as in any of the previous claims, wherein said Group III-nitride material is GaN or AlN.

5. A device as in any of the previous claims, wherein said second layer is in direct contact with said top layer.

6. A device as in any of the previous claims, further comprising a third layer positioned between said second layer and said further layer.

7. A device as in any of the previous claims, wherein said top layer comprises at least in part closed pores such as bubbles, voids, inclusions or micropores.

8. A device as in any of the previous claims, wherein said top layer has a porosity of between 10 and 90 %.

9. A device as in any of the previous claims, wherein said top layer has a thickness of between 10 nm and 3 µm.

10. A device as in any of the previous claims, wherein said second layer has a thickness of between 1 nm and 1000 nm.

11. A device as in any of the previous claims, wherein said second layer has a thickness of between 1 nm and 20 nm, preferably of between 5 and 15 nm.

12. A device as in any of the previous claims, wherein the second layer is a layer made of a SiGe material and wherein the further layer is a GaN layer.

13. A device as in any of claims 1 to 12, wherein the top layer comprises at least in part closed pores, such as bubbles, voids or micropores, wherein the second layer is a layer made of a SiGe material and wherein the further layer is a GaN layer.

14. A device as in any of claims 1 to 12, wherein the second layer is a layer made of Ge or is a layer made of graded SiGe, the Ge concentration in said graded SiGe increasing in a direction away from said substrate; and wherein the further layer is a GaN layer.

15. A FET, a LED, a laser diode, a HEMT or a heterojunction bipolar transistor comprising a device as in any of the previous claims.

16. A device as in any of the previous claims, wherein an electronic circuitry is integrated in said silicon substrate.

17. A device as in any of the previous claims, wherein an optoelectronic element or a FET is formed in the Group III-nitride layer.

18. Method for forming a device comprising a Group III-nitride material on silicon, comprising the steps of:
• providing a silicon substrate comprising a top layer, said top layer being :
- a top layer consisting essentially of porous Silicon, or
- a castellated top layer, or
- a two-dimensionally submicron patterned layer,
• subjecting said silicon substrate with said top layer to a Ge comprising substance, thereby forming a second layer on said top layer, said second layer being a Ge layer or a SiGe layer,
• subjecting the silicon substrate with the Ge or SiGe layer to a substance comprising a Group III element and a substance comprising N, thereby forming a further layer of a Group III-nitride material directly on said second layer or on an intermediate layer present on said second layer.

19. Method as in claim 18, further comprising the step of thermally annealing said second layer prior to the step of subjecting said silicon substrate with said Ge or SiGe layer to a substance comprising a Group III element and a substance comprising N to form a further layer of a Group III-nitride material.

20. Method as in claim 19, wherein said step of thermally annealing is performed at a temperature between 500°C and 1300°C.

21. Method as in claim 19 or 20, wherein said step of thermally annealing is performed at a temperature between 500°C and 1100°C.

22. Method as in any of claims 18 to 21, wherein the step of subjecting said silicon substrate with said top layer to a substance comprising Ge is performed by plasma enhanced chemical vapour deposition, thermal evaporation, close space vapour transport or molecular beam epitaxy.

23. Method as in any of claim 18 to 22 wherein an intermediate device is stored after the step of forming the second layer on said top layer.

24. Method as in any of claims 18 to 23, wherein the step of subjecting said silicon substrate with said Ge or SiGe layer to a substance comprising a Group III element and a substance comprising N is performed by a metal organic chemical vapour deposition process, by molecular bean epitaxy or Hydride vapour phase epitaxy.

25. Method as in claim 24, wherein said step is performed at a temperature between 500°C and 1300°C.

26. Method as in claim 24 or 25, wherein said step is performed at a temperature between 1000°C and 1100°C.

27. Method as in any of claims 18 to 26, wherein said Group III element is Ga.

28. Method as in any of claims 18 to 27, wherein said Group III-nitride material is GaN.

29. Method as in any of claims 18 to 26, wherein said Group III element is Al.

30. Method as in any of claims 18 to 26 or 29, wherein said Group III-nitride material is AlN.

31. Method as in any of claims 18 to 30 further comprising the step of forming an intermediate layer, such as an AlN layer, between the step of subjecting said silicon substrate with said top layer to a substance comprising Ge and the step of subjecting said silicon substrate with said Ge or SiGe layer to a substance comprising a Group III element and a substance comprising N.

32. Method as in any of claims 18 to 31, wherein the deposition of a Group III-nitride layer, such as a GaN layer, is performed at two different temperatures between 500°C and 1300°C.

33. Method as in claim 32 wherein the first part of said deposition step is performed at a temperature of between 400°C and 800°C followed by a step at temperature of between 800°C and 1200°C.

34. A method for forming a template device before the deposition of a Group III-nitride material, said method comprising the steps of:
• providing a silicon substrate comprising a top layer, said top layer being :
- a top layer consisting essentially of porous Silicon, or
- a castellated top layer, or
- a two-dimensionally submicron patterned layer,
• subjecting said silicon substrate top layer to a substance comprising Ge, thereby forming on said top layer a second layer, said second layer being a Ge layer or a SiGe layer,
• followed by the step of thermally annealing said second layer.

35. Method as in claim 34 further comprising the step of storing the device for a predetermined time.

36. Use of a template device for the deposition of a Group III-nitride material, said template device comprising a substrate that comprises a silicon substrate having a top layer, said top layer being :
- a top layer consisting essentially of porous Silicon, or
- a castellated top layer, or
- a two-dimensionally submicron patterned layer,
and on said top layer a second layer, said second layer being a Ge or a SiGe layer.

## Patentansprüche

1. Vorrichtung, die umfasst:
• ein Substrat, das ein Siliciumsubstrat mit einer Oberschicht umfasst, wobei die Oberschicht ist:
- eine Oberschicht, die im Wesentlichen aus porösem Silicium besteht, oder
- eine mit Zinnen versehene Oberschicht, oder
- eine Schicht mit zweidimensionaler Submikrometerstruktur,
• eine zweite Schicht auf der Oberschicht, wobei die zweite Schicht eine Ge-Schicht oder eine SiGe-Schicht ist, und
• eine weitere Schicht aus einem Gruppe-III-Nitrid-Material direkt auf der zweiten Schicht oder auf einer Zwischenschicht, die auf der zweiten Schicht vorhanden ist.

2. Vorrichtung nach einem der vorstehenden Ansprüche, wobei die Zusammensetzung der zweiten Schicht gradiert ist.

3. Vorrichtung nach einem der vorstehenden Ansprüche, wobei die Ge-Konzentration im Material der zweiten Schicht in eine Richtung weg vom Substrat erhöht ist.

4. Vorrichtung nach einem der vorstehenden Ansprüche, wobei das Gruppe-III-Nitridmaterial GaN oder AIN ist.

5. Vorrichtung nach einem der vorstehenden Ansprüche, wobei die zweite Schicht mit der Oberschicht in direktem Kontakt steht.

6. Vorrichtung nach einem der vorstehenden Ansprüche, die ferner eine dritte Schicht umfasst, die zwischen der zweiten Schicht und der weiteren Schicht positioniert ist.

7. Vorrichtung nach einem der vorstehenden Ansprüche, wobei die Oberschicht zumindest teilweise geschlossene Poren wie z. B. Blasen, Hohlräume, Einschlüsse oder Mikroporen umfasst.

8. Vorrichtung nach einem der vorstehenden Ansprüche, wobei die Oberschicht eine Porosität zwischen 10 und 90 % aufweist.

9. Vorrichtung nach einem der vorstehenden Ansprüche, wobei die Oberschicht eine Dicke zwischen 10 nm und 3 µm aufweist.

10. Vorrichtung nach einem der vorstehenden Ansprüche, wobei die zweite Schicht eine Dicke zwischen 1 nm und 1000 nm aufweist.

11. Vorrichtung nach einem der vorstehenden Ansprüche, wobei die zweite Schicht eine Dicke zwischen 1 nm und 20 nm, vorzugsweise zwischen 5 nm und 15 nm, aufweist.

12. Vorrichtung nach einem der vorstehenden Ansprüche, wobei die zweite Schicht eine aus einem SiGe-Material hergestellte Schicht ist und wobei die weitere Schicht eine GaN-Schicht ist.

13. Vorrichtung nach einem der Ansprüche 1 bis 12, wobei die Oberschicht zumindest teilweise geschlossene Poren wie z. B. Blasen, Hohlräume oder Mikroporen umfasst, wobei die zweite Schicht eine aus einem SiGe-Material hergestellte Schicht ist und wobei die weitere Schicht eine GaN-Schicht ist.

14. Vorrichtung nach einem der Ansprüche 1 bis 12, wobei die zweite Schicht eine aus Ge hergestellte Schicht oder eine aus gradiertem SiGe hergestellte Schicht ist, wobei die Ge-Konzentration im gradierten SiGe in eine Richtung weg vom Substrat zunimmt; und wobei die weitere Schicht eine GaN-Schicht ist.

15. FET, LED, Laserdiode, HEMT oder Bipolartransistor mit Heteroübergang, der bzw. die eine Vorrichtung nach einem der vorstehenden Ansprüche umfasst.

16. Vorrichtung nach einem der vorstehenden Ansprüche, wobei eine Elektronikschaltung im Siliciumsubstrat integriert ist.

17. Vorrichtung nach einem der vorstehenden Ansprüche, wobei ein optoelektronisches Element oder ein FET in der Gruppe-III-Nitridschicht gebildet ist.

18. Verfahren zum Bilden einer Vorrichtung, die ein Gruppe-III-Nitrid-Material auf Silicium umfasst, das die Schritte umfasst:
• Bereitstellen eines Siliciumsubstrats, das eine Oberschicht umfasst, wobei die Oberschicht ist:
- eine Oberschicht, die im Wesentlichen aus porösem Silicium besteht, oder
- eine mit Zinnen versehene Oberschicht, oder
- eine Schicht mit zweidimensionaler Submikrometerstruktur,
• Aussetzen des Siliciumsubstrats mit der Oberschicht gegenüber einer Ge-umfassenden Substanz, wodurch eine zweite Schicht auf der Oberschicht gebildet wird, wobei die zweite Schicht eine Ge-Schicht oder eine SiGe-Schicht ist,
• Aussetzen des Siliciumsubstrats mit der Ge- oder SiGe-Schicht gegenüber einer Substanz, die ein Gruppe-III-Element umfasst, und einer Substanz, die N-umfasst, wodurch eine weitere Schicht aus einem Gruppe-III-Nitrid-Material direkt auf der zweiten Schicht oder auf einer Zwischenschicht gebildet wird, die auf der zweiten Schicht vorhanden ist.

19. Verfahren nach Anspruch 18, das ferner den Schritt des thermischen Glühens der zweiten Schicht vor dem Schritt des Aussetzens des Siliciumsubstrats mit der Ge- oder SiGe-Schicht zu einer Substanz, die ein Gruppe-III-Element umfasst, und einer Substanz, die N umfasst, zum Bilden einer weiteren Schicht eines Gruppe-III-Nitrid-Materials.

20. Verfahren nach Anspruch 19, wobei der Schritt des thermischen Glühens bei einer Temperatur zwischen 500 °C und 1300 °C durchgeführt wird.

21. Verfahren nach Anspruch 19 oder 20, wobei der Schritt des thermischen Glühens bei einer Temperatur zwischen 500 °C und 1100°C durchgeführt wird.

22. Verfahren nach einem der Ansprüche 18 bis 21, wobei der Schritt des Aussetzens des Siliciumsubstrats mit der Oberschicht zu einer Substanz, die Ge umfasst, durch plasmaunterstützte chemische Gasphasenabscheidung, thermische Verdampfung, Close-Space-Dampftransport oder Molekularstrahlepitaxie durchgeführt wird.

23. Verfahren nach einem der Ansprüche 18 bis 22 wobei eine Zwischenvorrichtung nach dem Schritt des Bildens der zweiten Schicht auf der Oberschicht gelagert wird.

24. Verfahren nach einem der Ansprüche 18 bis 23, wobei der Schritt des Aussetzens des Siliciumsubstrats mit der Ge- oder SiGe-Schicht zu einer Substanz, die ein Gruppe-III-Element umfasst, und einer Substanz, die N umfasst, durch einen Prozess der metallorganischen chemischen Gasphasenabscheidung, durch Molekularstrahlepitaxie oder Hydridgasphasenepitaxie durchgeführt wird.

25. Verfahren nach Anspruch 24, wobei der Schritt bei einer Temperatur zwischen 500 °C und 1300 °C durchgeführt wird.

26. Verfahren nach Anspruch 24 oder 25, wobei der Schritt bei einer Temperatur zwischen 1000 °C und 1100 °C durchgeführt wird.

27. Verfahren nach einem der Ansprüche 18 bis 26, wobei das Gruppe-III-Element Ga ist.

28. Verfahren nach einem der Ansprüche 18 bis 27, wobei das Gruppe-III-Nitrid-Material GaN ist.

29. Verfahren nach einem der Ansprüche 18 bis 26, wobei das Gruppe-III-Element Al ist.

30. Verfahren nach einem der Ansprüche 18 bis 26 oder 29, wobei das Gruppe-III-Nitrid-Material AIN ist.

31. Verfahren nach einem der Ansprüche 18 bis 30 ferner umfassend den Schritt des Bildens einer Zwischenschicht, wie z. B. einer AlN-Schicht, zwischen dem Schritt des Aussetzens des Siliciumsubstrats mit der Oberschicht zu einer Substanz, die Ge umfasst, und dem Schritt des Aussetzens des Siliciumsubstrats mit der Ge- oder SiGe-Schicht zu einer Substanz, die ein Gruppe-III-Element umfasst, und einer Substanz, die N umfasst.

32. Verfahren nach einem der Ansprüche 18 bis 31, wobei das Abscheiden einer Gruppe-III-Nitrid-Schicht, wie z. B. einer GaN-Schicht, in zwei unterschiedlichen Temperaturen zwischen 500 °C und 1300 °C durchgeführt wird.

33. Verfahren nach Anspruch 32 wobei der erste Teil des Abscheideschritts bei einer Temperatur zwischen 400 °C und 800 °C durchgeführt wird, worauf ein Schritt bei einer Temperatur zwischen 800 °C und 1200 °C folgt.

34. Verfahren zum Bilden einer Template-Vorrichtung vor Abscheiden eines Gruppe-III-Nitrid-Materials, wobei das Verfahren die Schritte umfasst:
• Bereitstellen eines Siliciumsubstrats, das eine Oberschicht umfasst, wobei die Oberschicht ist:
- eine Oberschicht, die im Wesentlichen aus porösem Silicium besteht, oder
- eine mit Zinnen versehene Oberschicht, oder
- eine Schicht mit zweidimensionaler Submikrometerstruktur,
• Aussetzen der Siliciumsubstratoberschicht gegenüber einer Substanz, die Ge umfasst, wodurch auf der Oberschicht eine zweite Schicht gebildet wird, wobei die zweite Schicht eine Ge-Schicht oder eine SiGe-Schicht ist,
• worauf der Schritt des thermischen Glühens der zweiten Schicht folgt.

35. Verfahren nach Anspruch 34 das ferner den Schritt des Lagerns der Vorrichtung für einen vordefinierten Zeitraum umfasst.

36. Verwendung einer Template-Vorrichtung zum Abscheiden eines Gruppe-III-Nitrid-Materials, wobei die Template-Vorrichtung ein Substrat umfasst, das ein Siliciumsubstrat mit einer Oberschicht umfasst, wobei die Oberschicht ist:
- eine Oberschicht, die im Wesentlichen aus porösem Silicium besteht, oder
- eine mit Zinnen versehene Oberschicht, oder
- eine Schicht mit zweidimensionaler Submikrometerstruktur, und
auf der Oberschicht eine zweite Schicht, wobei die zweite Schicht eine Ge- oder eine SiGe-Schicht ist.

## Revendications

1. Dispositif comprenant :
• un substrat comprenant un substrat de silicium ayant une couche supérieure, ladite couche supérieure étant :
- une couche supérieure constituée essentiellement de silicium poreux, ou
- une couche supérieure crénelée, ou
- une couche structurée submicronique bidimensionnelle,
• une deuxième couche sur ladite couche supérieure, ladite deuxième couche étant une couche de Ge ou une couche de SiGe, et
• une autre couche d'un matériau de nitrure de groupe III directement sur ladite deuxième couche ou sur une couche intermédiaire présente sur ladite deuxième couche.

2. Dispositif selon la revendication précédente, dans lequel la composition de ladite seconde couche est calibrée.

3. Dispositif selon l'une quelconque des revendications précédentes, dans lequel la concentration de Ge dans ledit matériau de ladite seconde couche est augmentée dans une direction s'écartant dudit substrat.

4. Dispositif selon l'une quelconque des revendications précédentes, dans lequel ledit matériau de nitrure de groupe III est du GaN ou de l'AlN.

5. Dispositif selon l'une quelconque des revendications précédentes, dans lequel ladite deuxième couche est en contact direct avec ladite couche supérieure.

6. Dispositif selon l'une quelconque des revendications précédentes, comprenant en outre une troisième couche positionnée entre ladite deuxième couche et ladite autre couche.

7. Dispositif selon l'une quelconque des revendications précédentes, dans lequel ladite couche supérieure comprend au moins en partie des pores fermés tels que des bulles, vides, inclusions ou micropores.

8. Dispositif selon l'une quelconque des revendications précédentes, dans lequel ladite couche supérieure a une porosité comprise entre 10 et 90 %.

9. Dispositif selon l'une quelconque des revendications précédentes, dans lequel ladite couche supérieure a une épaisseur comprise entre 10 nm et 3 µm.

10. Dispositif selon l'une quelconque des revendications précédentes, dans lequel ladite seconde couche a une épaisseur comprise entre 1 nm et 1000 nm.

11. Dispositif selon l'une quelconque des revendications précédentes, dans lequel ladite deuxième couche a une épaisseur comprise entre 1 nm et 20 nm, de préférence, entre 5 et 15 nm.

12. Dispositif selon l'une quelconque des revendications précédentes, dans lequel la deuxième couche est une couche constituée d'un matériau de SiGe et dans lequel l'autre couche est une couche de GaN.

13. Dispositif selon l'une quelconque des revendications 1 à 12, dans lequel la couche supérieure comprend au moins en partie des pores fermés, tels que des bulles, vides ou micropores, dans lequel la deuxième couche est une couche constituée d'un matériau de SiGe et dans lequel l'autre couche est une couche de GaN.

14. Dispositif selon l'une quelconque des revendications 1 à 12, dans lequel la deuxième couche est une couche constituée de Ge ou est une couche constituée de SiGe calibré, la concentration de Ge dans ledit SiGe calibré augmentant dans une direction s'écartant dudit substrat ; et dans lequel l'autre couche est une couche de GaN.

15. TEC, DEL, diode laser, TGME ou transistor bipolaire à hétérojonction comprenant un dispositif selon l'une quelconque des revendications précédentes.

16. Dispositif selon l'une quelconque des revendications précédentes, dans lequel un ensemble de circuits électroniques est intégré dans ledit substrat de silicium.

17. Dispositif selon l'une quelconque des revendications précédentes, dans lequel un élément optoélectronique ou un TEF est formé dans la couche de nitrure de groupe III.

18. Procédé de formation d'un dispositif comprenant un matériau de nitrure de groupe III sur du silicium, comprenant les étapes suivantes :
• fourniture d'un substrat de silicium comprenant une couche supérieure, ladite couche supérieure étant :
- une couche supérieure constituée essentiellement de silicium poreux, ou
- une couche supérieure crénelée, ou
- une couche structurée submicronique bidimensionnelle,
• soumission dudit substrat de silicium avec ladite couche supérieure à une substance comprenant du Ge, formant ainsi une deuxième couche sur ladite couche supérieure, ladite deuxième couche étant une couche de Ge ou une couche de SiGe,
• soumission du substrat de silicium avec la couche de Ge ou de SiGe à une substance comprenant un élément de groupe III et une substance comprenant du N, formant ainsi une autre couche d'un matériau de nitrure de groupe III directement sur ladite seconde couche ou sur une couche intermédiaire présente sur ladite seconde couche.

19. Procédé selon la revendication 18, comprenant en outre l'étape de recuit thermique de ladite deuxième couche avant l'étape de soumission dudit substrat de silicium avec ladite couche de Ge ou de SiGe à une substance comprenant un élément de groupe III et une substance comprenant du N pour former une autre couche d'un matériau de nitrure de groupe III.

20. Procédé selon la revendication 19, dans lequel ladite étape de recuit thermique est effectuée à une température comprise entre 500 °C et 1300 °C.

21. Procédé selon la revendication 19 ou 20, dans lequel ladite étape de recuit thermique est effectuée à une température comprise entre 500 °C et 1100 °C.

22. Procédé selon l'une quelconque des revendications 18 à 21, dans lequel l'étape de soumission dudit substrat de silicium avec ladite couche supérieure à une substance comprenant du Ge est effectuée par dépôt chimique en phase vapeur activé par plasma, évaporation thermique, transport de vapeur en espace fermé ou épitaxie par faisceaux moléculaires.

23. Procédé selon l'une quelconque des revendications 18 à 22, dans lequel un dispositif intermédiaire est stocké après l'étape de formation de la deuxième couche sur ladite couche supérieure.

24. Procédé selon l'une quelconque des revendications 18 à 23, dans lequel l'étape de soumission dudit substrat de silicium avec ladite couche de Ge ou de SiGe à une substance comprenant un élément de groupe III et une substance comprenant du N est effectuée par un procédé de dépôt chimique en phase vapeur par composés organométalliques, par épitaxie par faisceaux moléculaires ou épitaxie en phase vapeur hybride.

25. Procédé selon la revendication 24, dans lequel ladite étape est effectuée à une température comprise entre 500 °C et 1300 °C.

26. Procédé selon la revendication 24 ou 25, dans lequel ladite étape est effectuée à une température comprise entre 1000 °C et 1100 °C.

27. Procédé selon l'une quelconque des revendications 18 à 26, dans lequel ledit élément de groupe III est du Ga.

28. Procédé selon l'une quelconque des revendications 18 à 27, dans lequel ledit élément de groupe III est du GaN.

29. Procédé selon l'une quelconque des revendications 18 à 26, dans lequel ledit élément de groupe III est de l'Al.

30. Procédé selon l'une quelconque des revendications 18 à 26 ou 29, dans lequel ledit matériau de nitrure de groupe III est de l'AlN.

31. Procédé selon l'une quelconque des revendications 18 à 30 comprenant en outre l'étape de formation d'une couche intermédiaire, telle qu'une couche d'AIN, entre l'étape de soumission dudit substrat de silicium avec ladite couche supérieure à une substance comprenant du Ge et l'étape de soumission dudit substrat de silicium avec ladite couche de Ge ou de SiGe à une substance comprenant un élément de groupe III et à une substance comprenant du N.

32. Procédé selon l'une quelconque des revendications 18 à 31, dans lequel le dépôt d'une couche de nitrure de groupe III, telle qu'une couche de GaN, est effectué à deux températures différentes entre 500 °C et 1300 °C.

33. Procédé selon la revendication 32, dans lequel la première partie de ladite étape de dépôt est effectuée à une température comprise entre 400 °C et 800 °C suivie par une étape à une température comprise entre 800 °C et 1200 °C.

34. Procédé de formation d'un dispositif de gabarit avant le dépôt d'un matériau de nitrure de groupe III, ledit procédé comprenant les étapes suivantes :
• fourniture d'un substrat de silicium comprenant une couche supérieure, ladite couche supérieure étant :
- une couche supérieure constituée essentiellement de silicium poreux, ou
- une couche supérieure crénelée, ou
- une couche structurée submicronique bidimensionnelle,
• soumission de ladite couche supérieure de substrat de silicium à une substance comprenant du Ge, formant ainsi sur ladite couche supérieure une deuxième couche, ladite deuxième couche étant une couche de Ge ou une couche de SiGe, et
• suivie par l'étape de recuit thermique de ladite deuxième couche.

35. Procédé selon la revendication 34, comprenant en outre l'étape de stockage du dispositif pendant un temps prédéterminé.

36. Utilisation d'un dispositif de gabarit pour le dépôt d'un matériau de nitrure de groupe III, ledit dispositif de gabarit comprenant un substrat qui comprend un substrat de silicium ayant une couche supérieure, ladite couche supérieure étant :
- une couche supérieure constituée essentiellement de silicium poreux, ou
- une couche supérieure crénelée, ou
- une couche structurée submicronique bidimensionnelle,
et sur ladite couche supérieure, une deuxième couche, ladite deuxième couche étant une couche de Ge ou une couche de SiGe.
